# DEMANDE DE BREVET EUROPEEN

(11) **EP 2 393 108 A1**
(43) Date de publication de la demande: **07.12.2011**
(21) Numéro de dépôt: 11354025.6
(22) Date de dépôt: 18.05.2011
(51) Int. Cl.: H01L 21/336, H01L 29/786

(54) **Transistor à effet de champ compact avec contre-électrode et procédé de réalisation**

(30) Priorité: 03.06.2010 FR 1002358
(71) Demandeur: Commissariat à l'Énergie Atomique et aux Énergies Alternatives, 75015 Paris (FR); STMicroelectronics (Crolles 2) SAS, 38920 Crolles (FR)
(72) Inventeur: Fenouillet-Béranger, Claire, 38000 Grenoble (FR); Thomas, Olivier, 38420 Revel (FR); Coronel, Philippe, 38530 Barraux (FR); Denorme, Stéphane, 38920 Crolles (FR)
(74) Mandataire: Talbot, Alexandre

(57) **Abrégé**

Un masque de gravure comportant le dessin de la délimitation de l'électrode de grille (9), d'un contact de source (12), d'un contact de drain (13) et d'un contact de contre-électrode est formé sur un substrat de type semi-conducteur sur isolant. Le substrat est recouvert par une couche en matériau diélectrique (5) et un matériau de grille. Le contact de contre-électrode est localisé dans le dessin de l'électrode de grille (9). Le matériau de grille est gravé pour définir l'électrode de grille (9), les contacts de source (12) et de drain (13) et le contact de contre-électrode (2). Une partie du substrat de support (2), à travers le dessin de la zone de contact de contre-électrode est libérée. Un matériau électriquement conducteur (22) est déposé sur la partie libre du substrat de support (2) pour former le contact de contre-électrode.

## Description

### Domaine technique de l'invention

L'invention est relative à un procédé de réalisation d'un transistor à effet de champ et à un transistor à effet de champ comportant :
- un substrat de support,
- un film en matériau diélectrique,
- un matériau semi-conducteur séparé du substrat de support par le film en matériau diélectrique,
- une électrode de grille,
- un contact électrique de substrat de support.

### État de la technique

Avec la réduction continue de leurs dimensions, les dispositifs actifs des circuits intégrés, comme les transistors, se heurtent à des phénomènes physiques, qui se traduisent par des effets parasites sur les caractéristiques électriques principales des dispositifs, par exemple l'effet canal court. Afin de remédier à un certain nombre de ces écueils, différentes solutions sont envisagées.

Les substrats sur lesquels les transistors sont intégrés ont été modifiés afin de réduire certains des phénomènes parasites des transistors. Ces substrats améliorés sont de type semi-conducteur sur isolant. Ils sont formés par une couche en matériau semi-conducteur séparée du substrat de support par un matériau diélectrique. Selon l'épaisseur de la couche en matériau semi-conducteur sur laquelle est intégré le transistor à effet de champ, le substrat est dit partiellement ou complètement déplété. Ainsi, pour un substrat complètement déplété, le canal de conduction du transistor occupe toute l'épaisseur du matériau semi-conducteur (couche semi-conductrice mince) alors que pour un substrat partiellement déplété, le canal du transistor n'en occupe qu'une portion (couche semi-conductrice plus épaisse).

En utilisant successivement les substrats de type semi-conducteur sur isolant partiellement déplété puis complètement déplété, il a été possible de poursuivre la course à la miniaturisation et au perfectionnement continu des transistors.

Les substrats de type semi-conducteur sur isolant complètement déplété ont ensuite été modifiés en diminuant l'épaisseur de la couche du matériau diélectrique et en intégrant une couche dopée dans le substrat de support. Cette couche dopée est formée à proximité de la couche diélectrique afin de former un plan de masse. Ce plan de masse permet un meilleur contrôle des effets parasites du transistor intégré sur la couche en matériau semi-conducteur, notamment l'effet canal court au moyen d'un meilleur contrôle de l'abaissement de la barrière induite par l'électrode de drain (DIBL). Cependant, l'utilisation d'un plan de masse requiert l'intégration d'une électrode de commande supplémentaire liée à ce plan de masse. Ceci se traduit par des contraintes supplémentaires au niveau du procédé de réalisation et également au niveau de la surface utilisée par le transistor.

Le document US 6611023 décrit un transistor à effet de champ muni d'une contre-électrode, cette contre-électrode est formée sous le canal de conduction par dopage du substrat de support. Elle est également formée sous une partie d'un motif d'isolation enrobant le dispositif pour permettre la prise de contact. Une connexion électrique est réalisée entre la contre-électrode et l'électrode de grille au travers du motif d'isolation.

Le transistor et son mode de réalisation ne sont pas optimum car il n'est pas possible de distinguer électriquement l'électrode de grille et la contre-électrode pour obtenir une plus grande flexibilité de fonctionnement. De plus, il est nécessaire de passer au travers du motif d'isolation pour obtenir la commande de la contre-électrode. Ce point est problématique lorsque l'on travaille dans des circuits denses car il faut également prendre en compte des marges de sécurité au niveau de cette prise de contact dans le motif d'isolation.

### Résumé de l'invention

L'invention a pour objet un procédé de réalisation d'un transistor à effet de champ muni d'une contre-électrode. Ce procédé permet un gain en compacité et est facile à mettre en oeuvre.

Pour satisfaire ce besoin, on prévoit un procédé selon les revendications annexées et en particulier un procédé comportant les étapes suivantes :
- prévoir un substrat de type semi-conducteur sur isolant avec un substrat de support, une couche en matériau semi-conducteur, et un matériau de grille,
- graver le matériau de grille, à partir d'un masque de gravure, pour définir dans le matériau de grille la délimitation de l'électrode de grille, d'une de zone de contact de contre-électrode, la zone de contact de contre-électrode étant localisée dans le dessin de l'électrode de grille,
- former le contact de contre-électrode dans la zone de contact de contre-électrode.

Ce procédé réalise l'autoalignement du contact de contre-électrode par rapport à l'électrode de grille ce qui permet un gain en compacité.

L'invention a également pour objet un transistor à effet de champ qui est muni d'une contre-électrode connectée électriquement à l'électrode de grille et qui est particulièrement compact et facile à réaliser. Pour satisfaire ce besoin, on prévoit un dispositif selon les revendications annexées et en particulier un dispositif dans lequel le contact électrique de substrat de support passe au travers de l'électrode de grille et au travers du film en matériau semi-conducteur.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- les figures 1 à 6 et 8 à 14 représentent, de manière schématique, en coupe ou en vue de dessus, des étapes particulières d'un procédé de réalisation selon l'invention,
- la figure 7 représente, de manière schématique, en coupe, une étape alternative à la figure 6 dans un autre procédé de réalisation selon l'invention,
- les figures 15 à 17 représentent, de manière schématique, en coupe, une première variante de procédé de réalisation selon l'invention,
- la figure 18 représente, de manière schématique, en coupe, une seconde variante de procédé de réalisation selon l'invention,
- les figures 19 et 20, représentent de manière schématique, en coupe, des troisième et quatrième variantes de procédé de réalisation selon l'invention,
- la figure 21 représente de manière schématique, en coupe, encore une cinquième variante de procédé de réalisation selon l'invention,
- la figure 22 représente en vue de dessus, le dessin d'un masque de gravure délimitant quatre transistors munis d'une contre-électrode pour former une cellule mémoire SRAM.

### Description d'un mode de réalisation préféré de l'invention

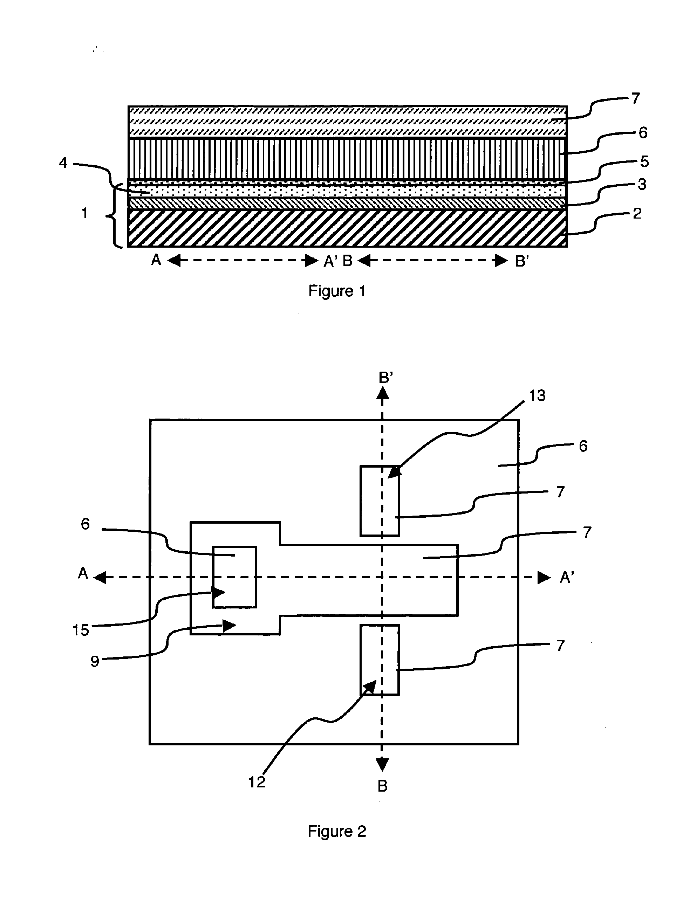

Le procédé de réalisation du dispositif à effet de champ selon l'invention est réalisé à partir d'un substrat 1 qui comporte, comme illustré à la figure 1, successivement un substrat de support 2, par exemple en matériau semi-conducteur, une couche en matériau diélectrique 3, un film en matériau semi-conducteur 4, un matériau diélectrique de grille 5, une couche en matériau de grille 6 et une couche de masquage 7. La couche de masquage 7 va servir de masque dur et est, par exemple, dans un matériau isolant, par exemple un nitrure de silicium ou un oxyde de silicium.

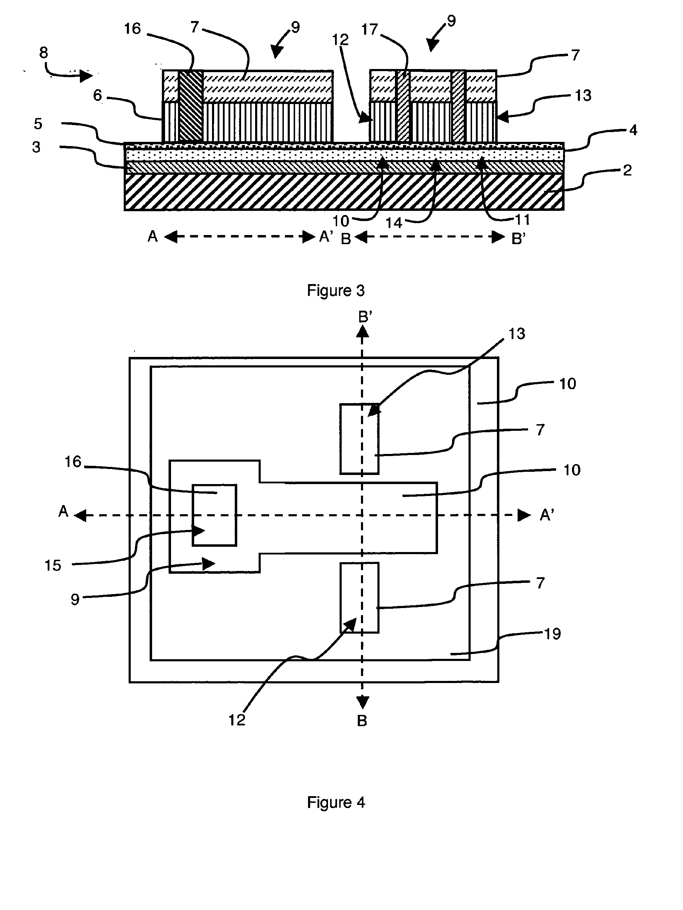

La figure 1 représente, à gauche ou à droite, des vues en coupe selon les lignes AA' et BB' illustrées aux figures 2 et 4 représentatives de vues de dessus d'étapes du procédé.

Ainsi, le substrat 1 est un substrat de type semi-conducteur sur isolant qui a été recouvert par un diélectrique de grille 5 et un matériau 6 pouvant servir d'électrode de grille, ce matériau de grille 6 ayant été lui-même recouvert par un matériau de masquage 7 servant de masque dur. A titre d'exemple, le diélectrique de grille a une épaisseur comprise entre 1 et 3 nm, le matériau de grille 6 a une épaisseur comprise entre 2 et 15 nm si c'est un métal ou une épaisseur comprise entre 30 et 80 nm si c'est un silicium polycristallin. Le matériau de masquage a, de préférence, une épaisseur comprise entre 20 et 50 nm.

Comme illustré aux figures 2 et 3, un masque de gravure 8 est formé dans la couche de masquage 7. Le masque de gravure 8 permet de définir et/ou de positionner les différents éléments constitutifs du transistor comme l'électrode de grille 9, des électrodes de source 10 et de drain 11 et des contacts de source 12 et de drain 13, les uns par rapport aux autres. A titre d'exemple, le masque de gravure 8 est formé par photolithographie et gravure.

Comme illustré à la figure 2, le masque de gravure 8 comporte le dessin de la délimitation de l'électrode de grille 9. Le dessin de l'électrode de grille 9 sert à délimiter le canal de conduction 14 et positionner les électrodes de source 10 et de drain 11 de part et d'autre du canal de conduction 14 (figure 3). Comme illustré à la figure 3, les électrodes de source 10 et de drain 11 et le canal de conduction 14 sont localisés dans la couche en matériau semi-conducteur 4.

Le masque de gravure 8 comporte préférentiellement le dessin des zones délimitant les futurs contacts de source 12 et de drain 13 qui seront formés sur les électrodes de source 10 et de drain 11.

Le masque de gravure 8 comporte, en plus, dans le dessin de l'électrode de grille 9, le dessin d'une zone d'accès 15 qui va définir le futur contact de contre-électrode. Cette zone d'accès 15 correspond à un motif fermé formé à l'intérieur de l'électrode de grille. Le dessin de la zone d'accès 15 et celui de l'électrode de grille 9 sont de polarités opposées.

Au moyen du dessin formé dans le masque de gravure 8, il est possible avec un seul niveau photolithographique de définir latéralement la position des électrodes de source 10, de drain 11 et des contacts de source 12 et de drain 13, par rapport à l'électrode de grille 9. Il y a ainsi auto-alignement de toutes les électrodes et des contacts cités ci-dessus. Il est également possible au moyen de ce niveau photolithographique de définir les dimensions des différents contacts. Le dessin conventionnel de l'électrode de grille 9 est complété par le dessin d'une zone d'accès 15 qui est formée à l'intérieure de cette électrode de grille 9.

Les formes de l'électrode de grille 9, des contacts de source 12, de drain 13 et de la zone d'accès 15 sont représentées dans le masque de gravure 8 par des zones pleines ou vides de la couche de masquage 7. La couche de masquage 7 sert de masque dur pour les étapes de gravure ultérieures. La couche de masquage 7 est donc choisie dans un matériau suffisamment résistant pour servir de masque dur. Avantageusement, afin de limiter les étapes technologiques, les zones représentatives de l'électrode de grille 9 et des contacts de source 12 et de drain 13 sont représentées par des zones pleines dans le masque de gravure (figure 3).

Comme illustré aux figures 3 et 4, une gravure anisotrope est réalisée afin de structurer les couches disposées entre le masque de gravure 8 et la couche en diélectrique de grille 5, dans le cas présent, seul le matériau de grille 6 est présent entre ces deux couches. La forme de l'électrode de grille 9 est définie, simultanément aux zones délimitant les contacts de source 12 et de drain 13 par des zones en matériau de grille 6 et en matériau de masquage 7 comme illustré à la figure 3 en coupe. Lors de la délimitation de l'électrode de grille 9, il y a également délimitation de la zone d'accès 15 dans l'électrode de grille 9. Les contacts de source 12 et drain 13 sont des motifs distincts de celui de l'électrode de grille sur les figures 2 et 4, mais ils peuvent également être liés au dessin de l'électrode de grille et séparé par la suite.

Une fois l'électrode de grille 9 réalisée, la zone d'accès 15 (et éventuellement les contacts de source 12 et de drain 13) délimités latéralement dans la couche de masquage 7 et le matériau de grille 6, le masquage de la zone d'accès 15 (et éventuellement de l'espace existant entre l'électrode de grille 9 et les futurs contacts de source 12 et de drain 13) est réalisé.

L'espace entre l'électrode de grille 9 et les futurs contacts de source et de drain correspond au volume disposé entre les parois latérales en regard de l'électrode de grille 9 et chacun des contacts de source 12 et de drain 13.

Le masquage peut être réalisé de différentes manières. A titre d'exemple, le masquage peut provenir de différentes étapes de photolithographies additionnelles qui ne laissent libre que la zone d'accès 15 ou que la zone située entre l'électrode de grille 9 et les contacts de source 12 et de drain 13. Dans ce cas de figure, un premier matériau d'obturation 16 et un second matériau d'obturation 17 sont déposés dans les zones laissées libres. Le premier matériau d'obturation 16 remplit la zone vide correspondant à la zone d'accès 15 alors que le second matériau d'obturation 17 remplit les deux zones vides disposées de part et d'autre de l'électrode de grille 9 entre l'électrode de grille 9 et les contacts de source 12 et de drain 13. Le second matériau d'obturation 17 évite tout court-circuit entre l'électrode de grille 9 et les contacts de source 12 et de drain 13.

Le premier matériau d'obturation 16 est, par exemple, un matériau de type alliage de silicium-germanium. De manière générale, le premier matériau d'obturation 16 est réalisé par un matériau qui peut être éliminé sélectivement par rapport aux autres matériaux présents.

Le second matériau d'obturation 17 est réalisé dans un matériau qui assure l'isolation électrique entre l'électrode de grille 9 et les contacts de source 12 et de drain 13 si ce dernier reste dans la structure finale. Le second matériau d'obturation 17 est, par exemple, un oxyde de silicium de type TEOS (tétraéthylorthosilicate). Si le second matériau d'obturation n'est pas conservé dans la structure finale, il peut être en matériau électriquement conducteur. Le choix des premier et second matériaux d'obturation est fait de manière à ce qu'il soit possible d'éliminer sélectivement le premier matériau d'obturation 16 par rapport au second matériau d'obturation 17.

Dans un mode de réalisation privilégié, le masquage de la zone d'accès 15 et le masquage des zones entre l'électrode de grille 9 et les contacts de source 12 et de drain 13 sont réalisés sans utiliser de niveau photolithographique supplémentaire. Le masquage est réalisé en utilisant le dépôt conforme du matériau 16 ou 17 utilisé pour reboucher la zone vide désirée suivi d'une gravure partielle de ce même matériau, de préférence une gravure isotrope avec une détection de fin de gravure. Afin de maîtriser la localisation du premier matériau d'obturation 16 et du second matériau d'obturation 17, il est nécessaire de définir dans le masque de gravure 8 les dimensions minimales de la zone d'accès 15 et la distance qui sépare l'électrode de grille 9 des contacts de source 12 et de drain 13, dans un plan parallèle à la surface du substrat 1. De manière préférentielle, afin de faciliter la réalisation du dispositif, il existe un écart de l'ordre de 10nm entre le trou de la zone d'accès 15 et chacun des contacts de source 12 et de drain 13.

La zone vide qui présente la dimension latérale la plus petite sera remplie en premier. Ainsi, si l'on souhaite déposer le premier matériau d'obturation 16 avant le second matériau d'obturation 17, il est nécessaire de dimensionner la taille de la zone d'accès 15 en conséquence. La zone d'accès 15 présentera alors une dimension longitudinale et/ou transversale inférieure à la distance minimale qui sépare l'électrode de grille 9 des contacts 12 et 13. Si l'on souhaite déposer le premier matériau d'obturation 16 après le second matériau d'obturation 17, les contraintes sur les dimensions seront inversées. De manière préférentielle, une marge de sécurité comprise entre 5 et 10% est utilisée afin d'assurer la différenciation des zones à remplir.

Au contraire, si les dimensions de la zone d'accès 15 et si la distance entre l'électrode de grille 9 et les contacts de source 12 et de drain 13 sont fixées, l'ordre de dépôt des matériaux 16 et 17 est imposé. Avantageusement, le premier matériau d'obturation 16 est déposé en dernier, c'est-à-dire après le second matériau d'obturation 17.

Le premier matériau déposé (parmi les matériaux d'obturation 16 et 17) est localisé dans la zone vide désirée au moyen d'un dépôt conforme suivi d'une gravure isotrope. De cette manière, une fois que la zone vide avec la dimension la plus petite est remplie par le matériau déposé, une gravure isotrope est réalisée. Cette gravure isotrope élimine le matériau d'obturation excepté dans la zone vide que l'on cherchait à remplir. Un procédé équivalent est utilisé pour localiser le matériau déposé à la suite.

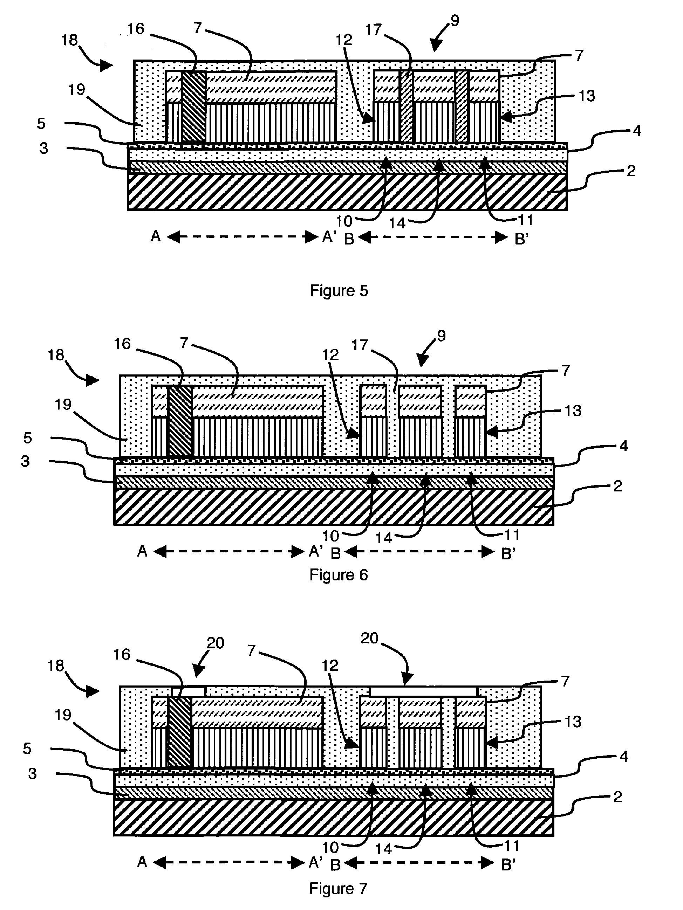

Comme illustré aux figures 4 et 5, une fois le premier matériau d'obturation 16 déposé et localisé dans la zone d'accès 15, un motif de délimitation 18 est formé. Ce motif de délimitation 18 provient d'un matériau de délimitation 19 qui est déposé pleine plaque. De ce fait, il est déposé au moins sur le diélectrique de grille 10 et sur le masque de gravure 8 et il remplit avantageusement toutes les zones vides existantes. Le motif de délimitation 18 est formé autour de l'électrode de grille 9 et autour des contacts de source 12 et de drain 13.

Dans un mode de réalisation particulier, illustré à la figure 6, il est envisageable de laisser libre les zones vides entre l'électrode de grille 9 et les contacts de source 12 et de drain 13 avant la formation du motif de délimitation 18. Dans ce cas, le matériau de délimitation 19, qui constitue le motif de délimitation 18, forme également le second matériau d'obturation 17. Avantageusement, le motif de délimitation 18 est réalisé dans un matériau électriquement isolant afin de former également un motif d'isolation autour de l'électrode de grille 9 et des contacts de source 12 et de drain 13. De ce fait, en variante, le second matériau d'obturation 17 et le matériau de délimitation 19 sont déposés à des instants différents et avec des matériaux qui peuvent être identiques ou différents.

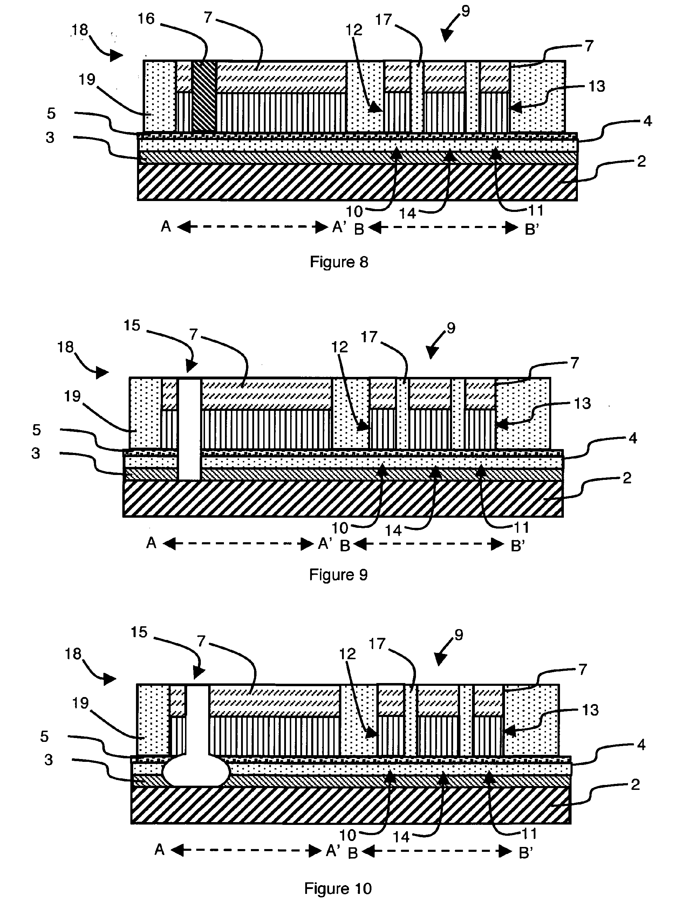

Comme illustré aux figures 7 et 8, le motif de délimitation 18 est structuré afin de laisser libre (c'est-à-dire non recouverte) une partie de la paroi supérieure de l'électrode de grille 9, une partie de la paroi supérieure du premier matériau d'obturation 16, une partie des parois supérieures des contacts de source 12 et de drain 13.

Dans un mode de réalisation particulier illustré à la figure 7, au moins une ouverture 20 est alors formée dans le motif de délimitation 18 pour découvrir les zones désirées. Dans un autre mode de réalisation particulier, illustré à la figure 8, les parois supérieures de l'électrode de grille 9, des contacts de source 12 et de drain 13 et du premier matériau d'obturation 16 sont intégralement laissées libres. Avantageusement, cette libération est réalisée au moyen d'un polissage mécano-chimique qui utilise la couche de masquage 7 en tant que couche d'arrêt. Cependant, il est également envisageable de réaliser un aplanissement de la face supérieure du motif de délimitation 18 suivi d'une étape de gravure qui libère l'électrode de grille 9, le premier matériau d'obturation 16 et les contacts de source 12 et de drain 13.

Si le second matériau d'obturation 17 est conservé dans la structure finale, il n'est pas nécessaire de prévoir une libération, au moins partielle, de sa surface supérieure. Dans le cas contraire, il faut libérer une partie de sa surface supérieure, cependant, cette libération peut être réalisée plus tard dans le procédé.

Comme illustré aux figures 9 et 10, le premier matériau d'obturation 16 est ensuite éliminé ce qui permet l'accès au diélectrique de grille 5. Le diélectrique de grille 5, le matériau semi-conducteur 4 puis la couche en matériau diélectrique 3 sont également éliminés par la suite au niveau de la zone d'accès 15. Les gravures peuvent être réalisées de manière isotrope (figure 10) ou anisotrope (figure 9) selon la configuration recherchée et/ou la surface de zone ouverte dans le motif de délimitation 18 au-dessus de la zone d'accès 15.

Une fois l'accès au substrat de support 2 réalisé, une couche de protection 21 est formée au moins sur les zones libres des matériaux électriquement conducteurs accessibles depuis la zone d'accès 15 sauf pour le substrat de support 2 et éventuellement l'électrode de grille 9. Dans la configuration présentée, une couche de protection 21 doit être formée au moins sur le matériau semi-conducteur 4. Cette couche de protection 21 peut être formée par tout procédé adapté, par exemple au moyen d'une oxydation sélective de la couche en matériau semi-conducteur 4 par rapport au substrat de support 2 et au matériau de grille 6.

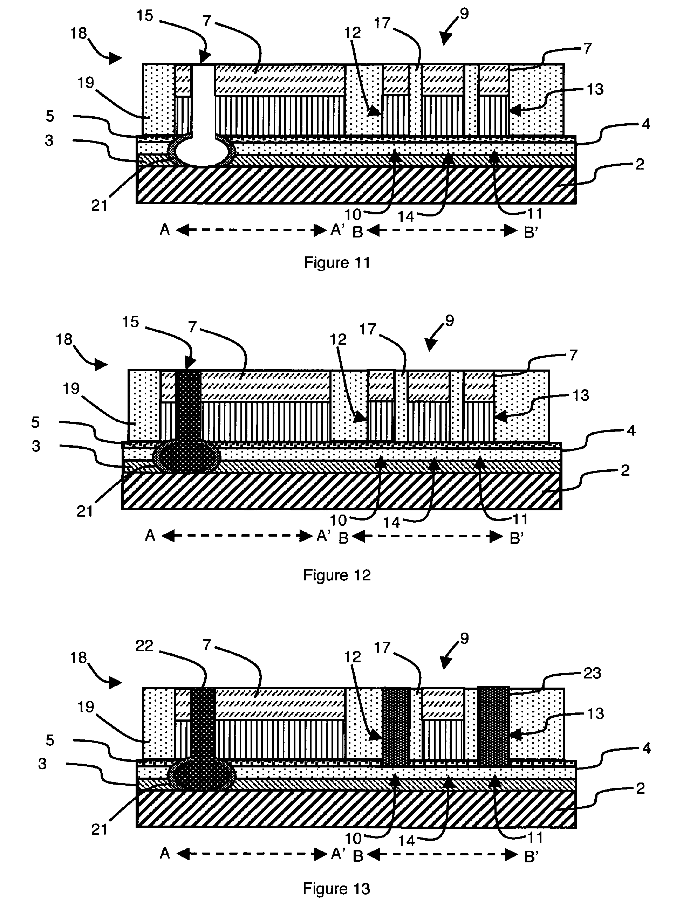

Dans un mode de réalisation particulier illustré à la figure 11, la gravure du matériau semi-conducteur 4 a été réalisée de manière isotrope, ce qui se traduit par une zone vide plus étendue dans les couches 3 et 4 que la surface de la zone d'accès 15 dans le masque de gravure 8 (figure 10) et/ou l'ouverture 20 associée dans le motif de délimitation 18. La couche de protection 21 est alors formée soit par oxydation, soit par dépôt d'un matériau électriquement isolant. Le matériau diélectrique formé est éliminé au niveau de la surface du substrat de support 2 par une gravure anisotrope. De cette manière, le dessin de la surface libre de la paroi supérieure du premier matériau d'obturation 16 (figure 7 ou 8) correspond au dessin de la zone libre sur le substrat de support 2. Ailleurs, la couche de protection 21 électriquement isolante est conservée. La couche de protection 21 protège la couche en matériau semi-conducteur 4 de tout court-circuit et elle délimite la surface effective de contact entre le substrat de support 2 et le futur contact de contre-électrode.

Avantageusement, pour obtenir un contact effectif important, il est nécessaire de libérer l'intégralité de la surface supérieure de la zone d'accès 15.

Comme illustré à la figure 12, une fois que le substrat de support 2 présente une zone libre dans la zone d'accès 15 et que la couche de protection 21 évite tout court-circuit avec au moins la couche en matériau semi-conducteur 4, le contact de contre-électrode peut être réalisé. Le contact est réalisé par le dépôt et la structuration d'un premier matériau électriquement conducteur 22, par exemple un métal ou un matériau semi-conducteur dopé. Avantageusement, si le substrat de support 2 est en silicium, en matériau à base de silicium ou de germanium, le dépôt du matériau 22 est précédé du dépôt d'une fine couche de métal. Cette couche de métal est soumise à un traitement thermique afin de former un siliciure et/ou un germaniure (non représenté) qui améliore le contact électrique entre le substrat de support 2 et le contact électrique de contre-électrode.

Comme illustré à la figure 13, les zones de contact de source 12 et de drain 13 sont alors au moins partiellement libérées afin d'avoir accès au matériau de grille 6 présent dans le fond de ces zones. La libération des zones de contact de source 12 et de drain 13 est réalisée par toute technique adaptée, par exemple au moyen d'une étape de photolithographie qui laisse découverte les faces supérieures de ces zones. De manière préférentielle, des matériaux différents sont localisés dans les zones de contact 12 et 13 comparés à celui ou à ceux présents au niveau de l'électrode de grille. Ce point peut être obtenu en modulant les dimensions des différents contacts comme cela a été explicité pour localiser les premier et second matériaux sacrificiels 16 et 17.

Le matériau de grille 6 puis le diélectrique de grille 5 sont alors éliminés afin de libérer au moins une partie de la couche en matériau semi-conducteur 4 qui forme les électrodes de source 10 et de drain 11 du transistor. Là encore, les contacts de source 12 et de drain 13 sont réalisés de manière conventionnelle par le dépôt d'un second matériau électriquement conducteur 23, par exemple un métal ou un matériau semi-conducteur dopé, identique ou non au premier matériau électriquement conducteur 22. Comme précédemment, le dépôt de ce matériau peut être avantageusement précédé de la formation d'un siliciure ou d'un germaniure. Dans ce mode de réalisation, les contacts de source 12 et de drain 13 et le contact de la contre électrode, c'est-à-dire du substrat de support 2 sont formés séparément.

Dans le cas où le premier matériau conducteur 22 est déposé de manière directionnelle, il n'est pas nécessaire dans le mode de réalisation illustré à la figure 10 de prévoir la couche de protection 21, car il ne peut y avoir contact entre cette électrode et le matériau semi-conducteur 4.

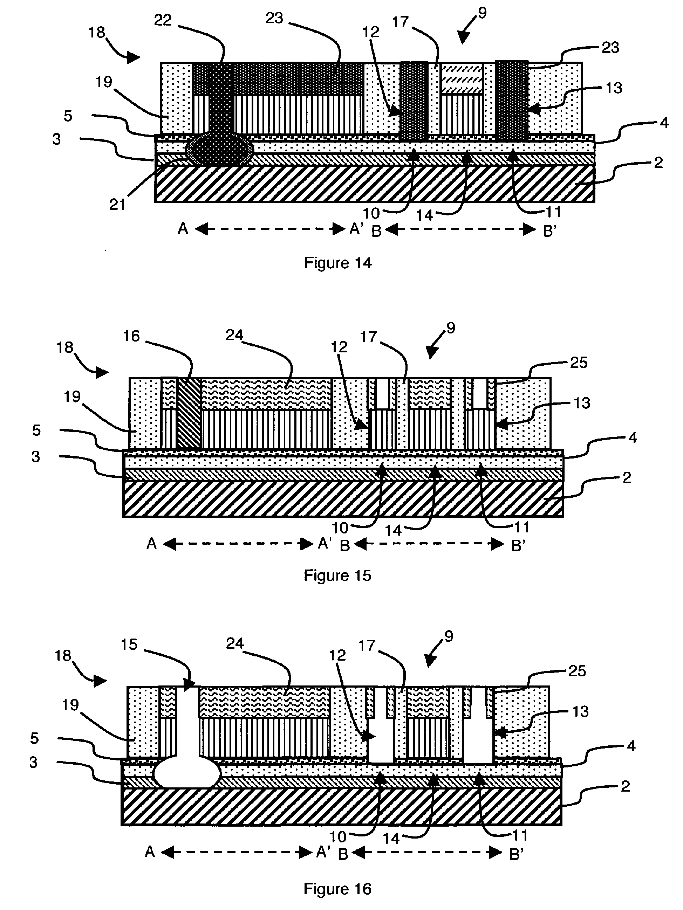

Comme illustré à la figure 14, la zone délimitant la futur électrode de grille 9 est également au moins partiellement libérée afin de rendre accessible une partie du matériau de grille 6 et autoriser la formation du contact de grille. Une fois la gravure au moins partielle du matériau de masquage réalisée, l'accès au matériau de grille 6 est possible, il est alors envisageable de remplacer le matériau de grille 6 existant par un autre et il est également possible de remplacer le diélectrique de grille 5 par un autre matériau présentant des caractéristiques plus avantageuses. Un matériau électriquement conducteur peut également être utilisé, ici à titre d'exemple, le second matériau électriquement conducteur 23 est utilisé. De cette manière, lorsque plusieurs transistors sont formés sur un substrat, il est possible de spécialiser les différents transistors en modifiant les matériaux formant l'électrode de grille 9.

Il est ensuite possible d'éliminer le motif de délimitation 18 et/ou le second matériau d'obturation 17. Le reste du transistor est réalisé de manière classique.

De cette manière, le contact de source 12 est connecté électriquement à l'électrode de source 10, le contact de drain 13 est connecté électriquement à l'électrode de drain 11. Le contact de contre-électrode est connecté électriquement au substrat de support 2 sans être connecté à la couche en matériau semi-conducteur 4.

Dans une autre variante de réalisation illustrée aux figures 15 à 17, le contact de contre-électrode est formé en même temps que les contacts de source 12 et de drain 13. L'électrode de grille 9 et les contacts de source 12 et de drain 13 sont alors formés par le même matériau électriquement conducteur.

Une fois le motif de délimitation 18 formé, ce dernier est structuré pour libérer la surface supérieure de la zone d'accès 15, de l'électrode de grille 9 et des contacts de source 12 et de drain 13. La structuration est réalisée par une étape d'aplanissement associée ou non à une étape de gravure. Il y a alors à la surface du substrat, le premier matériau d'obturation 16, le masque de gravure 8 et le second matériau d'obturation 17 (figure 8).

Le masque de gravure 8 est ensuite éliminé ce qui rend accessible le matériau de grille 6 et une partie des parois latérales du premier matériau d'obturation 16 et du second matériau d'obturation 17.

Comme illustré à la figure 15, un matériau de recouvrement 24 est ensuite déposé de manière conforme sur les surfaces libres. Ce matériau de recouvrement 24 a une épaisseur constante et il reproduit la topographie de surface initiale. L'épaisseur déposée du matériau de recouvrement est telle que la zone vide représentative de l'électrode de grille 9, à l'intérieur du motif de délimitation 18, est rebouchée. De cette manière, dans le motif de délimitation 18 au niveau de l'électrode de grille 9, le masque de gravure 8 a été intégralement remplacé par le matériau de recouvrement 24. La forme de l'électrode de grille 9 est conservée.

En revanche, les zones de contact de source 12 et de drain 13 présentant des dimensions latérales et longitudinales chacune supérieures à la plus petite des dimensions parmi les dimensions latérales et longitudinales de l'électrode de grille 9, il y a alors formation d'un espaceur latéral 25 sur les parois latérales. Cet espaceur latéral 25 réduit la surface accessible du matériau de grille 6, mais il ne rebouche pas cette zone de contact. Il est également possible au moyen d'une étape de photolithographie additionnelle de venir localiser le matériau de recouvrement uniquement dans l'électrode de grille 9 et ainsi éviter la formation d'un espaceur latéral 25 dans les zones de contact de source 12 et de drain 13. Le matériau 24 est alors déposé par toute technique adaptée.

Une fois l'électrode de grille 9 recouverte par le matériau de recouvrement 24, le premier matériau d'obturation 16 est éliminé. Ce qui rend accessible le diélectrique de grille 5 dans la zone d'accès 15 qui est alors éliminé.

Comme illustré à la figure 16, le matériau de grille 6 des zones de contact 12 et 13 et la couche en matériau semi-conducteur 4 sous la zone d'accès 15 sont éliminés. De manière avantageuse, si le matériau de grille 6 et la couche en matériau semi-conducteur 4 sont dans le même matériau ou réagissent à la même chimie de gravure, il est possible d'éliminer simultanément ces deux matériaux. La gravure peut être anisotrope ou isotrope.

Si une gravure anisotrope est utilisée pour éliminer le matériau de grille 6 et si il existe des espaceurs 25 en matériau de recouvrement 24, il y a formation d'espaceurs en matériau de grille 6 sur les parois latérales des zones de contact. En l'absence de ces espaceurs, le matériau de grille 6 est intégralement éliminé de la zone de contact.

Si une gravure isotrope est utilisée pour éliminer le matériau de grille 6 dans les zones de contacts de source 12 et de drain 13, la présence ou non d'espaceurs 25 en matériau de recouvrement 24 est sans conséquence. Cependant, il faut remarquer qu'il y aura consommation du matériau de grille 6 depuis la surface libre de la zone d'accès 15.

La couche en matériau semi-conducteur 4 est structurée pour rendre accessible une partie de la couche en matériau diélectrique 3. La couche en matériau diélectrique 3 est également structurée pour permettre l'accès au substrat de support 2. L'étendue de substrat de support 2 accessible dépend des procédés de gravure utilisés. Avantageusement, les gravures utilisées pour éliminer la couche en matériau diélectrique 5 et la couche en matériau semi-conducteur 4 sont de type isotrope afin d'accroître les surfaces libérées.

Une fois le diélectrique de grille 5 accessible dans les zones de contact 12 et 13, ce dernier doit être éliminé. Il est avantageux d'éliminer simultanément le diélectrique de grille 5 et la couche en matériau diélectrique 3 si ces derniers sont des matériaux qui réagissent aux mêmes chimies de gravure.

Une fois que le substrat de support 2 est accessible dans la zone d'accès 15, il est nécessaire de former la couche de protection 21 afin d'éviter tout court-circuit entre le substrat le support 2 et les autres électrodes. Comme expliqué précédemment, la couche de protection est dans un matériau électriquement isolant et elle est localisée. La localisation de la couche de protection 21 peut provenir d'une formation sélective et/ou d'une formation généralisée suivie d'une structuration.

La couche de protection 21 évite tout contact électrique entre la couche en matériau semi-conducteur 4 et le substrat de support 2. La couche de protection 21 peut également éviter le contact électrique entre l'électrode de grille 9 et le substrat de support 2.

La couche de protection 21 est formée, par exemple, par oxydation ou nitruration de la couche en matériau semi-conducteur 4, c'est-à-dire par la transformation superficielle de la couche en matériau semi-conducteur 4 en un matériau électriquement isolant. Il en est de même de la transformation superficielle de la couche en matériau de grille 6 en un matériau électriquement isolant. Si lors de cette transformation, le substrat de support 2 est également transformé, la couche de protection 21 formée sur le substrat de support 2 est éliminée au moins partiellement pour autoriser l'accès à une partie du substrat de support 2. Cet accès peut être réalisé par une gravure plasma anisotrope qui n'élimine que la couche de protection 21 visible depuis le haut de la zone d'accès 15. Il est également envisageable d'obtenir cet accès par une gravure anisotrope par voie humide ou par plasma si la couche de protection 21 présente une épaisseur plus importante à proximité des zones à recouvrir en comparaison du substrat de support 2. Il est également envisageable d'obtenir cet accès par une gravure anisotrope par voie humide ou par plasma si la couche de protection 21 présente une différence de composition qui autorise une vitesse de gravure plus importante à proximité du substrat de support 2 comparée aux autres zones recouvertes. De cette manière, la couche de protection 21 est au moins localisée sur le bord de la couche en matériau semi-conducteur 4.

Si la couche en matériau semi-conducteur 4 n'est pas accessible dans les zones de contact, il est nécessaire de la découvrir. Le diélectrique de grille 5 dans les zones de contact est éliminé au plus tard à cette étape, mais il peut être éliminé avant, par exemple, lors de la gravure de la couche en matériau diélectrique 3.

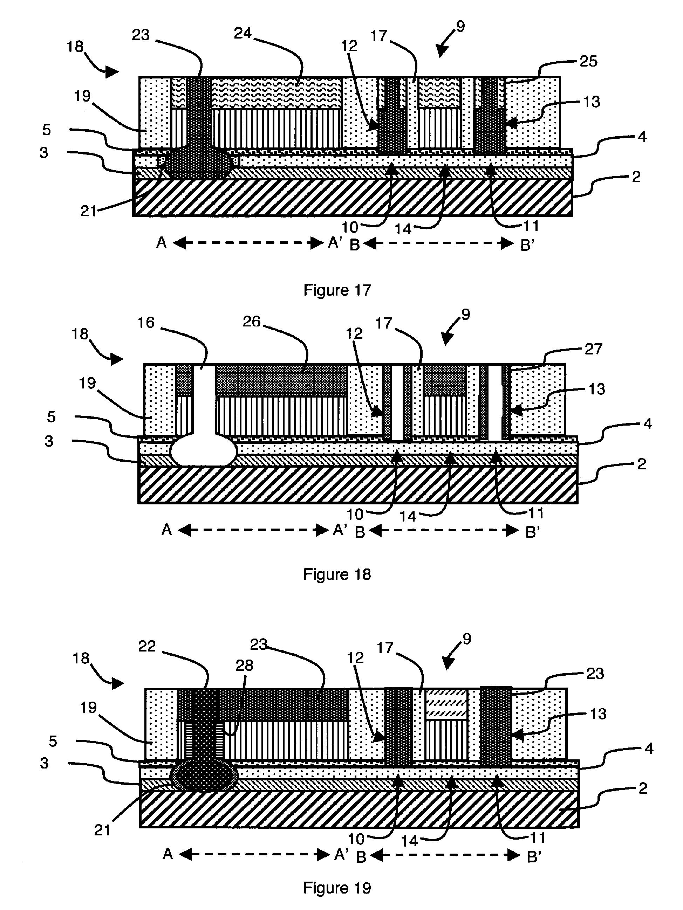

Comme illustré à la figure 17, à partir de cette structure, on peut réaliser les contacts de source 12, de drain 13 et de contre-électrode simultanément car toutes les électrodes sont accessibles. Ces contacts sont formés, par exemple, par dépôt d'un matériau électriquement conducteur, par exemple le second matériau électriquement conducteur 23, ici un métal. La localisation du matériau électriquement conducteur pour former des contacts spécifiques est réalisée avantageusement par une étape de polissage mécano-chimique qui utilise le motif de délimitation 18 comme couche d'arrêt.

Avantageusement, une étape de siliciuration est réalisée sur les zones libres en matériau semi-conducteur 4 avant le dépôt d'un métal afin d'améliorer le contact électrique. Ainsi, un siliciure est formé sur la couche en matériau semi-conducteur 4 dans les zones de contact de source 12 et de drain 13, sur le substrat de support 2 dans la zone d'accès 15 et dans l'électrode de grille 9 sous réserve que ces matériaux puissent réagir avec un métal pour former un siliciure ou tout autre matériau à comportement métallique réalisé à base de matériau semi-conducteur.

Dans une autre variante de réalisation illustrée à la figure 18, une couche en second matériau de recouvrement 26 est déposée et structurée. L'épaisseur déposée est choisie de telle sorte que la couche en second matériau de recouvrement 26 forme des espaceurs latéraux 27 dans les zones de contact de source 12 et de drain 13 et remplit le volume vide de l'électrode de grille 9. De cette manière, le dessus de l'électrode de grille 9 est recouvert par le second matériau de recouvrement 26 ce qui empêche de former par la suite un contact de grille. De ce fait, ce mode de réalisation n'est intéressant que si le contact de contre-électrode formé dans la zone d'accès 15 connecte électriquement l'électrode de grille 9 au moyen de leurs parois latérales communes.

Les zones vides présentes dans les zones de contact de source 12 et de drain 13 sont ensuite remplies par un matériau électriquement conducteur qui forme les contacts de source 12 et de drain 13 effectifs. Ces contacts de source 12 et de drain 13 sont espacés de l'électrode de grille 9 par l'épaisseur de second matériau d'obturation 17 et par l'épaisseur de l'espaceur latéral 27 en second matériau de recouvrement 26. Ces deux épaisseurs permettent de maîtriser la valeur des capacités parasites qui existent entre les contacts de source 12 et drain 13 et l'électrode de grille 9.

Selon les modes de réalisation utilisés, il est possible avec peu d'étapes additionnelles d'obtenir soit une électrode de grille et une contre-électrode complètement dissociée d'un point de vue électrique soit des électrodes reliées électriquement. Afin d'obtenir l'indépendance électrique entre l'électrode de grille et le contact de contre électrode, il est nécessaire d'avoir une couche électriquement isolante entre le premier matériau électriquement conducteur 22 et les matériaux constituant l'électrode de grille 9.

Comme illustré à la figure 19, cette couche électriquement isolante peut être formée par la couche de protection 21 et au moins un autre matériau isolant 28. Par exemple, si la couche de protection 21 est formée par oxydation d'un matériau semi-conducteur ou conducteur, il peut y avoir formation de la couche de protection 21 sur les parois latérales libres de la couche en matériau semi-conducteur 4 et d'un autre matériau isolant 28 sur les parois du matériau de grille 6. La structuration de la couche électriquement isolante permet de localiser un isolant électrique sur les bords de la couche en matériau semi-conducteur 4 et sur les bords du matériau de grille 6 tout en libérant au moins une partie du substrat de support 2.

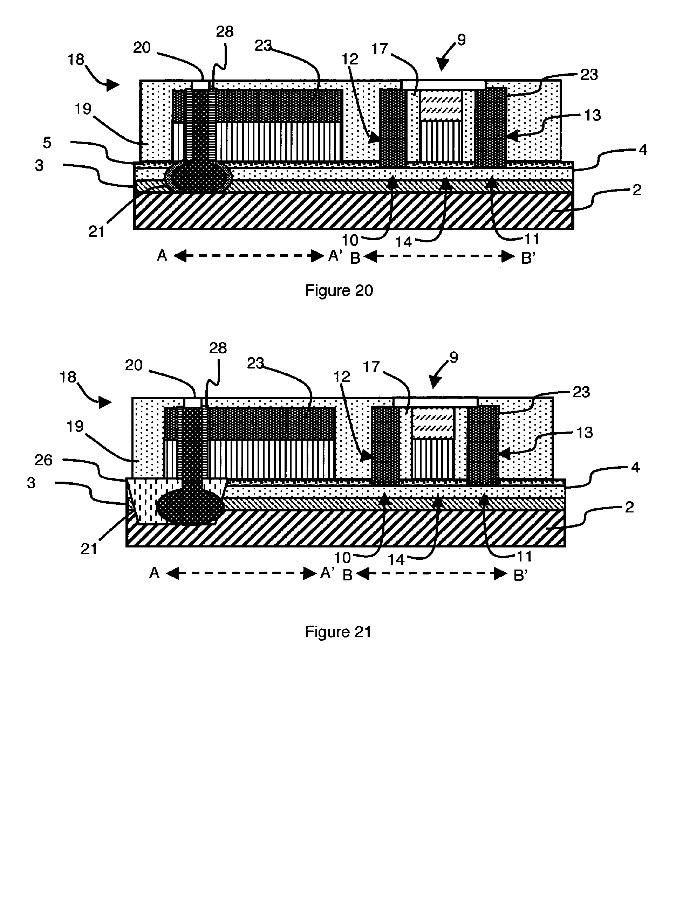

Comme illustré à la figure 20, le film électriquement isolant peut également être formé par la couche de protection 21 et éventuellement par un autre matériau isolant 28 si l'ouverture 20 formée dans le motif de délimitation 18 est inférieure à l'étendue de la zone d'accès 15. Ainsi, l'ouverture 20 formée au-dessus de la zone d'accès 15 ne libère pas une partie du masque de gravure 8 autour de la zone d'accès 15. Lors de la gravure anisotrope du premier matériau d'obturation 16, il y a formation d'un film continu en matériau 28 sur la paroi de la zone d'accès 15, c'est-à-dire que le premier film d'obturation 16 recouvre la paroi latérale du matériau de grille 6 et du masque de gravure 8. La couche de protection 21 et/ou le matériau 28 peut être formée par le premier matériau d'obturation 16 si ce dernier est électriquement isolant ou alors par transformation, par exemple oxydation, du premier matériau d'obturation 16. La libération d'une partie du substrat de support 2 est réalisée avantageusement au moyen d'une gravure anisotrope.

Dans une variante de réalisation non représentée, le film isolant peut également être formé après la réalisation du contact de contre-électrode une fois que le matériau de grille 6 a été éliminé. Dans ce cas, il est nécessaire de libérer l'accès aux parois latérales du contact de contre-électrode. Ceci peut être réalisé en éliminant les matériaux formant l'électrode de grille et en déposant de manière conforme un matériau isolant électriquement. Avantageusement, cette couche isolante peut être formée par le diélectrique de grille lorsque celui ci est déposé.

Ainsi, comme illustré par exemple aux figures 14, 17 et 19, il est possible d'obtenir un transistor à effet de champ qui comporte une électrode de grille 9 et une contre-électrode. Le transistor comporte successivement un substrat de support 2, une couche en matériau diélectrique isolant 3, un film en matériau semi-conducteur 4. Le film en matériau semi-conducteur 4 est séparé du substrat de support 2 par la couche en matériau diélectrique 3 et il est recouvert par la couche en matériau diélectrique de grille 5 et le matériau de grille 6. L'électrode de grille 9 est séparée du film en matériau semi-conducteur 4 par le matériau diélectrique de grille 5. La contre-électrode est formée dans le substrat de support 2 et sa commande est réalisée au moyen du contact de substrat de support formé à partir de la zone d'accès 15. Le contact de substrat de support passe à travers l'électrode de grille 9 et à travers le film en matériau semi-conducteur 4 sans réaliser de court-circuit avec le film en substrat de support. Ceci est réalisé, par exemple, au moyen de la couche en protection 21 qui isole électriquement le contact de substrat de support 2 du film en matériau semi-conducteur 4.

Cette intégration du contact à l'intérieur de l'électrode de grille 9 et du film en matériau semi-conducteur 4 permet de réaliser un gain important au niveau de la compacité du circuit final. La surface du dispositif est conservée tout comme les performances électriques par rapport aux autres architectures. Il n'est plus nécessaire de réaliser le contact de contre électrode dans le motif d'isolation adjacent. Ceci permet de diminuer les contraintes dimensionnelles au niveau des motifs d'isolation dans les zones de forte densité. Cela évite également les problèmes de court-circuit et les capacités parasites dans les zones où plusieurs contre-électrodes étaient prolongées pour assurer des prises de contact sûres.

Lorsque plusieurs transistors sont formés sur le film en matériau semi-conducteur 4, il est nécessaire d'intégrer également des motifs d'isolation électrique. Ces motifs d'isolation électrique ont pour but d'empêcher les porteurs de charges de migrer de manière parasite d'un transistor vers un autre.

Le film en matériau semi-conducteur 4 est structuré de manière à définir des zones actives dans lesquelles un ou plusieurs transistors sont formés. Les parties complémentaires de ces zones actives sont les motifs d'isolation. Les motifs d'isolation sont formés soit par un matériau électriquement isolant soit par une zone vide, c'est-à-dire une zone non remplie par un matériau solide.

Dans un mode de réalisation particulier, la zone active est définie après dépôt du premier et du second matériaux d'obturation. Ainsi, la zone active présente la même forme que le transistor. L'intégralité de l'électrode de grille 9 est formée au-dessus du film en matériau semi-conducteur 4.

Il est également possible de définir la zone active au moyen d'une étape de photolithographie spécifique. Cette étape est avantageusement réalisée avant le dépôt du matériau de délimitation 19, si ce dernier est isolant électriquement et est conservé dans la structure finale. La zone active peut également être définie une fois que les transistors sont réalisés.

Il est également envisageable de réaliser le transistor une fois que les zones actives et les motifs d'isolation sont formés. Dans ce cas, la partie de l'électrode de grille qui incorpore la zone de contact est avantageusement formée au-dessus de la zone active.

Dans une autre variante de réalisation illustrée à la figure 21, la zone d'accès 15 est localisée au-dessus d'un motif d'isolation. Comme dans les modes de réalisation précédents, le matériau de grille 6 est structuré au moyen du masque de gravure 8. Les premier et second matériaux d'obturation sont déposés et le motif de délimitation 18 est formé (figures 7, 8). Le premier matériau d'obturation 16 est éliminé et il laisse libre le matériau de grille 5 ou une partie du motif d'isolation. Comme dans les cas précédents, les matériaux disposés sous la zone d'accès sont éliminés pour permettre la connexion du substrat de support 2.

Dans le cas particulier illustré à la figure 21, il n'y a pas de connexion électrique parasite entre le film en semi-conducteur 4 et le contact de contre-électrode. Cependant, il est également possible de déposer une couche de protection afin de s'assurer qu'il n'existe pas de court-circuit entre la contre-électrode et le film en matériau semi-conducteur 4.

Dans le mode de réalisation illustré, il y a connexion électrique depuis le fond du motif d'isolation 26 et depuis une partie latérale du motif d'isolation 26. Il est particulièrement avantageux de réaliser la connexion depuis une paroi latérale car il n'est pas nécessaire de prolonger la contre-électrode jusque sous le motif d'isolation 26. Cependant, ce mode de réalisation est un peu plus compliqué à mettre en oeuvre car il faut tenir compte de l'inclinaison de l'interface entre le motif d'isolation 26 et la zone active lorsque l'on place la zone d'accès.

De manière préférentielle, les contre-électrodes sont réalisées par dopage du substrat de support. De manière encore plus préférentielle, les contre-électrodes sont formées lors de la définition des zones actives en matériau semi-conducteur et des zones d'isolation. Ceci permet d'obtenir facilement un autoalignement des contre-électrodes avec les zones actives.

Dans un autre mode de réalisation, la contre-électrode peut être alignée avec le dispositif. Pour ce faire, le contact de zone d'accès 15 est obstruée tout comme les espaces séparant l'électrode de grille 9 des contacts de source 12 et de drain 13. Une fois ce dessin monobloc formé, le matériau semi-conducteur 4 et une partie du substrat de support 2 sont gravés au moyen de ce dessin ce qui limite l'extension latérale de la contre-électrode au dessin de l'électrode de grille et de la surface entre les électrodes de source et de drain.

Cette approche permet de définir la position du contact de contre-électrode à l'intérieur du dessin de l'électrode de grille ce qui est particulièrement avantageux lorsque la contre-électrode est localisée uniquement sous l'électrode de grille et non sous les électrodes de source et de drain.

Cette approche permet également de changer la nature du matériau formant la contre-électrode une fois le dispositif formé. Ce point est particulièrement avantageux lorsque le matériau semi-conducteur 4 et le matériau du substrat de substrat sont réactifs au même agent de dégradation. Si la contre-électrode est connectée à une des électrode de source ou de drain, il n'est pas possible d'éliminer la contre-électrode sans éliminer également le matériau semi-conducteur 4. Il y a alors destruction du transistor à effet de champ.

L'utilisation d'un transistor à effet de champ comportant une contre-électrode avec un contact de contre-électrode formé dans l'électrode de grille est particulièrement intéressant car il permet un gain de place. Ce gain de place est d'autant plus important que le contact formé commande simultanément l'électrode de grille et la contre-électrode. Dans les exemples présentés en vue de dessus, le contact de contre-électrode est disposé sensiblement au centre de ce qui forme la tête de grille, mais il est également possible de décaler cette zone de contact. Ce décalage est d'autant plus intéressant que des contacts différents sont formés dans le cas où l'électrode de grille et la contre-électrode sont dissociées électriquement.

De cette manière, il devient possible de réaliser une cellule mémoire de type SRAM à quatre transistors de manière simple et compact. Le schéma électrique de cette cellule est divulgué dans le document US2009/0129142.

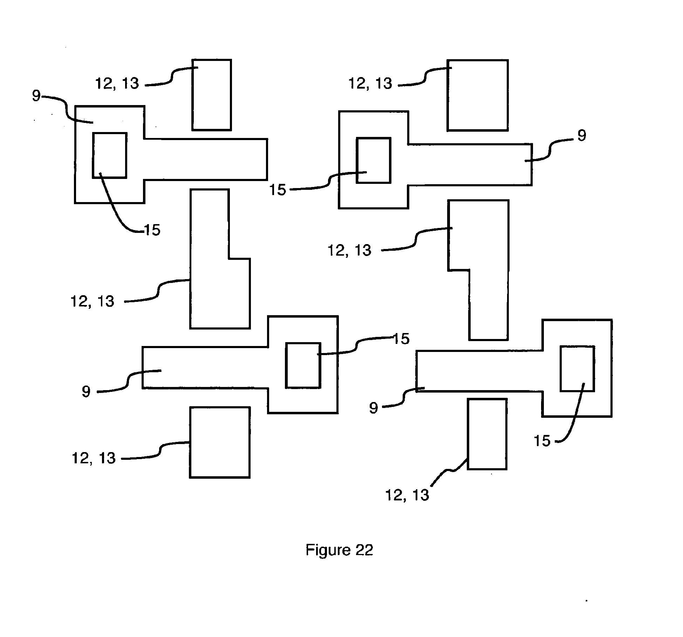

Pour obtenir une telle cellule, il suffit d'utiliser un masque de gravure illustré à la figure 22. Ce masque 8 comporte le dessin des quatre électrodes de grille représentatives des quatre transistors formant la cellule mémoire. La disposition et l'orientation des différentes électrodes de grille 9 et zones d'accès 15 permettent un gain de place maximal, mais d'autres possibilités que celles présentées sont envisageables.

Dans la cellule mémoire SRAM à quatre transistors, il y a deux transistors NMOS et deux transistors PMOS. Un transistor NMOS est connecté en série avec un transistor PMOS, de ce fait, il y a deux paires de transistors montés en série. Chaque paire de transistors est formée sur une zone active, il y a donc deux zones actives distinctes dans une cellule mémoire.

Les transistors NMOS et PMOS ayant des performances électriques prédéfinies, ils ont des dimensions prédéterminées au niveau de la longueur et de la largeur du canal de conduction. Une des dimensions du canal de conduction est définie par l'électrode de grille 9 alors que l'autre dimension est définie par la taille de la zone active. Il en résulte que les dimensions des électrodes de grille entre les transistors NMOS et PMOS ne sont pas obligatoirement identiques. Dans un mode de réalisation avantageux déjà cité plus haut, la largeur de la zone active est liée à la largeur des contacts de source et drain. Pour obtenir des zones actives de largeurs différentes, il est alors nécessaire d'utiliser des contacts de source et de drain de tailles différentes. La zone active comporte alors des contacts de source et de drain de tailles différentes selon qu'ils sont associés à une transistor PMOS ou NMOS.

Il n'est pas obligatoire que chaque transistor comporte une zone d'accès car dans la cellule mémoire recherchée, il existe une contre-électrode associée à une zone active, donc à deux transistors. Il suffit que l'un des deux transistors de la zone active comporte une zone d'accès. Les connexions électriques manquantes, sont réalisées de manière conventionnelle au moyen des niveaux électriques d'interconnexion. Avantageusement, seuls les transistors dont l'électrode de grille est connectée électriquement à la contre-électrode présente une zone d'accès.

Ainsi, au moyen de ce masque de gravure 8 spécifique et en reprenant le procédé décrit plus haut, il est possible d'obtenir de manière simple et industrielle, une cellule mémoire SRAM à quatre transistor ayant une contre-électrode qui présente de très bonnes performances d'un point de vue du comportement électrique.

Dans les modes de réalisation décrits ci-dessus, les contacts de source et drain sont délimités simultanément avec l'électrode de grille ce qui permet un autoalignement rapide et efficace des différentes électrodes. Il est également envisageable de délimiter les contacts de source ou de drain avant ou après la délimitation de l'électrode de grille. Dans ce cas, il y a une pré-délimitation dans le matériau de grille au moyen d'un motif plus large que la délimitation finale de l'électrode qui doit être formée par la suite. Il est également envisageable de former de manière différente, typiquement de manière conventionnelle, les contacts de source et de drain.

## Revendications

1. Procédé de réalisation d'un transistor à effet de champ **caractérisé en ce qu'**il comprend les étapes suivantes :
- prévoir un substrat (1) comportant successivement un substrat de support (2), une couche électriquement isolante (3), une couche en matériau semi-conducteur (4), et une couche en matériau de grille (6),
- graver le matériau de grille (6), à partir d'un masque de gravure (8), pour définir la délimitation d'une électrode de grille (9) et la délimitation d'une zone de contact (15) de contre-électrode du substrat de support (2), dans le matériau de grille (6), la zone de contact (15) de contre-électrode étant délimitée à l'intérieur du dessin de l'électrode de grille (9),
- libérer une partie du substrat de support (2) dans la zone de contact (15) de contre-électrode,
- former le contact de contre-électrode dans la zone de contact (15) de contre-électrode.

2. Procédé selon la revendication 1 **caractérisé en ce qu'**il comporte, la formation d'une couche de protection (21) qui recouvre la couche en matériau semi-conducteur (4) et laisse libre une partie du substrat de support (2), dans la zone de contact (15) de contre-électrode.

3. Procédé selon l'une des revendications 1 et 2, **caractérisé en ce qu'**il comporte lors de la délimitation de l'électrode de grille (9), le positionnement des électrodes de source (10) et de drain (11) dans la couche en matériau semiconducteur, la délimitation d'un contact de source (12) et d'un contact de drain (13) dans le matériau de grille (6) au moyen du masque de gravure (8).

4. Procédé selon la revendication 3, **caractérisé en ce qu'**il comporte, après gravure du matériau de grille (6), le dépôt d'un matériau d'obturation (17, 19) pour remplir un espace situé entre l'électrode de grille (9) et les contacts de source et de drain (12, 13) formés dans le matériau de grille (6).

5. Procédé selon la revendication 4, **caractérisé en ce qu'**il comporte la gravure de la couche en matériau semi-conducteur (4) dans la zone d'accès (15) après le dépôt du matériau d'obturation (17, 19).

6. Procédé selon l'une quelconque des revendications 1 à 5, **caractérisé en ce qu'**il comporte le remplissage de la zone de contact (15) par un matériau sacrificiel (16).

7. Procédé selon la revendication 6, **caractérisé en ce qu'**il comporte le dépôt d'un matériau de délimitation (19) et sa gravure pour libérer l'accès à une partie du matériau sacrificiel (16), une partie du contact de source (12) et du contact de drain (13) en matériau de grille (6).

8. Procédé selon la revendication 7, **caractérisé en ce qu'**il comporte après gravure du matériau de délimitation (19), la formation simultanée du contact (15) de contre-électrode et des contacts de source (12) et de drain (13) par dépôt d'un matériau électriquement conducteur.

9. Procédé selon l'une quelconque des revendications 2 à 8, dans lequel libérer une partie du substrat de support (2) comporte une gravure isotrope de la couche en matériau semi-conducteur (4).

10. Procédé selon l'une quelconque des revendications 2 à 9, dans lequel libérer une partie du substrat de support (2) comporte une gravure isotrope d'une couche en matériau diélectrique (3) localisée entre une couche en matériau semi-conducteur (4) et un matériau de grille (6).

11. Transistor à effet de champ comportant :
- un substrat de support (2),
- un film en matériau diélectrique (3),
- un film en matériau semi-conducteur (4) séparé du substrat de support (2) par la couche en matériau diélectrique (3),
- une électrode de grille (9) séparée du film en matériau semi-conducteur (4) par un matériau diélectrique de grille (5),
- un contact (15) électrique de substrat de support (2),
transistor **caractérisé en ce que** le contact électrique de substrat de support (2) passe au travers de l'électrode de grille (9) et au travers du film en matériau semi-conducteur (4).

12. Transistor selon la revendication 11 **caractérisé en ce qu'**un film de protection (21) isole électriquement le contact électrique de substrat de support du film en matériau semi-conducteur (4).
